## Europäisches Patentamt

## European Patent Office

## Office européen des brevets

(11) Veröffentlichungsnummer: **0 008 379**
**B1**

(12) **EUROPÄISCHE PATENTSCHRIFT**

(45) Veröffentlichungstag der Patentschrift:
**24.03.82**

(21) Anmeldenummer: **79102639.6**

(22) Anmeldetag: **25.07.79**

(51) Int. Cl.³: **H 01 L 21/68,** B 65 G 47/91,
B 25 J 9/00

(54) **Einrichtung für das Aufnehmen/Ablegen und Transportieren von kleinen Werkstücken.**

(30) Priorität: **18.08.78 US 934776**

(43) Veröffentlichungstag der Anmeldung:
**05.03.80 Patentblatt 80/5**

(45) Bekanntmachung des Hinweises auf die Patenterteilung:
**24.03.82 Patentblatt 82/12**

(84) Benannte Vertragsstaaten:
**DE FR GB**

(56) Entgegenhaltungen:
**FR-A-2 072 138**
**FR-A-2 295 569**

(73) Patentinhaber: **International Business Machines Corporation, Armonk, N.Y. 10504 (US)**

(72) Erfinder: **Gates, Gerald Alan, P.O. Box 26, Jericho Center, Vermont 05465 (US)**

(74) Vertreter: **Katzenberger, Richard, Dipl.-Ing. et al, Schönaicher Strasse 220, D-7030 Böblingen (DE)**

## Einrichtung für das Aufnehmen/Ablegen und Transportieren von kleinen Werkstücken

Die Erfindung bezieht sich auf eine Einrichtung für das Aufnehmen/Ablegen und Transportieren von kleinen Werkstücken, z.B. Halbleiterchips, an Bearbeitungsstationen.

Solche Einrichtungen sind bereits bekannt. So ist in der französischen Patentschrift 2 295 569 eine derartige Einrichtung beschrieben, bei der eine Düse mittels einer pneumatisch betätigbaren Vorrichtung zum Aufnehmen und Ablegen von Halbleiterplättchen vertikal bewegbar ist.

Aus der französischen Patentschrift 2 072 138, die ebenfalls eine Einrichtung zum Transport kleiner flacher Werkstücke, wie Halbleiterchips, zum Gegenstand hat, ist ein Drehventil bekannt, das aus einer fest angeordneten unteren und einer drehbaren oberen Platte besteht. Die Platten weisen auf konzentrischen Kreisen angeordnete Öffnungen auf.

Schliesslich ist in der US Patentschrift 3 453 714 eine Einrichtung für das Aufnehmen/Ablegen von kleinen Werkstücken, z.B. von Halbleiterchips offenbart. Diese werden an verschiedenen, entlang einer Kreisbahn angeordneten Stationen für die Bearbeitung und den Weitertransport abgelegt und aufgenommen. Die Einrichtung enthält eine Anzahl von Düsen, die an einer Hub- und Dreheinrichtung in gleichen Winkelabständen befestigt sind. Diese wird schrittweise in vorgegebene Winkelstellungen gedreht, in welchen die Werkstücke in eine Bearbeitungsebene abgesenkt und aus dieser angehoben werden. Die Steuerung der Düsen erfolgt durch ein Drehventil, durch das in den Winkelstellungen der Dreheinrichtung nach einem vorgebenen Programm zu den Düsen Unterdruck/Überdruck für das Aufnehmen/Ablegen von Werkstücken übertragbar ist.

Die bekannte Einrichtung ist so ausgebildet, dass ein zentraler Antrieb vorgesehen ist, durch den die Düsen über mechanisch gekoppelte Betätigungsmittel gedreht bzw. angehoben und abgesenkt werden. Das Drehventil, welches den Unterdruck/Überdruck der Düsen für das Aufnehmen/Ablegen von Werkstücken steuert, ist ebenfalls durch mechanische Betätigungsmittel mit dem zentralen Antrieb gekoppelt. Daraus ergibt sich der Nachteil, dass bei einer hohen Arbeitsgeschwindigkeit der Einrichtung ein vorgegebener Programmablauf nicht mit ausreichender Genauigkeit eingehalten werden kann.

Es ist die Aufgabe der vorliegenden Erfindung, eine Einrichtung für das Aufnehmen/Ablegen und Transportieren von kleinen Werkstücken zwischen Bearbeitungsstationen, die entlang einer Kreisbahn angeordnet sind, so auszubilden, dass ein vorgegebener Betriebsablauf betriebssicher eingehalten werden kann.

Die genannte Aufgabe wird bei einer Einrichtung für das Aufnehmen/Ablegen und Transportieren von Werkstücken gemäss dem Oberbegriff des Patentanspruchs 1 durch die in dessen Kennzeichen angeführten Merkmale gelöst.

Die genannte Lösungsmerkmale ermöglichen eine Vereinfachung der Einrichtung für das Aufnehmen/Ablegen und Transportieren von kleinen Werkstücken durch eine zusätzliche Auswertung des Drehventils für das pneumatisch betätigte Heben und Senken der Düsen an den Bearbeitungsstationen.

Die Erfindung wird anhand von Abbildungen näher erläutert.

Es zeigen:

Fig. 1 die Gesamtanordnung der Einrichtung für das Aufnehmen/Ablegen und Transportieren von kleinen Werkstücken mit einem Ausschnitt in Querschnittdarstellung,

Fig. 2 eine Querschnittsdarstellung des Drehventils entlang der in Fig. 4 dargestellten Schnittlinie 2-2,

Fig. 3 eine Draufsicht des in Fig. 2 dargestellten Drehventils entlang der Schnittlinie 3-3,

Fig. 4 eine Draufsicht des in Fig. 2 dargestellten Drehventils entlang der in Fig. 2 dargestellten Schnittlinie 4-4,

Fig. 5 die Diagramme der an einer Düse bzw. deren Hubeinrichtung bewirkten Luftdruckänderungen im Verlauf einer Drehung der Düse um 360°.

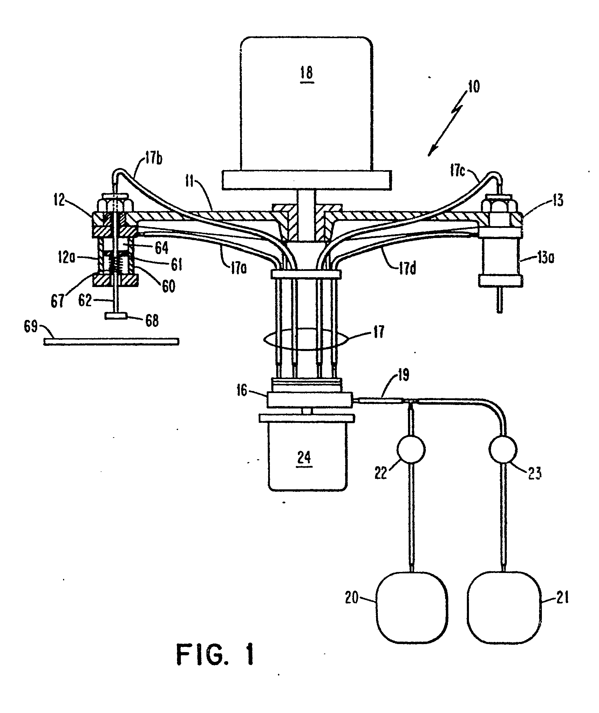

Bei der in Fig. 1 dargestellten Einrichtung 10 für das Aufnehmen/Ablegen und Transportieren von kleinen Werkstücken ist eine Anzahl von gemeinsam durch einen Träger 11 drehbaren Tragarmen vorgesehen, von denen in der Abbildung die beiden Tragarme 12 und 13 dargestellt sind. Der Drehantrieb der Tragarme erfolgt durch den Schrittmotor 18. An den Enden der beiden Tragarme 12 und 13 sind die beiden Tragköpfe 12a und 13a befestigt. Diese sind über Verbindungsleitungen 17a bis 17d, ein Drehventil 16, eine Anzahl von parallel angeordneten Verbindungsleitungen 19 und diesen zugeordneten Ventilen 22 bzw. 23 mit einem Unterdruckerzeuger 20 bzw. einem Überdruckerzeuger 21 verbunden. Das Drehventil 16 ist mit einem Schrittmotor 24 verbunden, der synchron mit dem Schrittmotor 18 für den Antrieb der Tragarme 12 und 13 angetrieben wird.

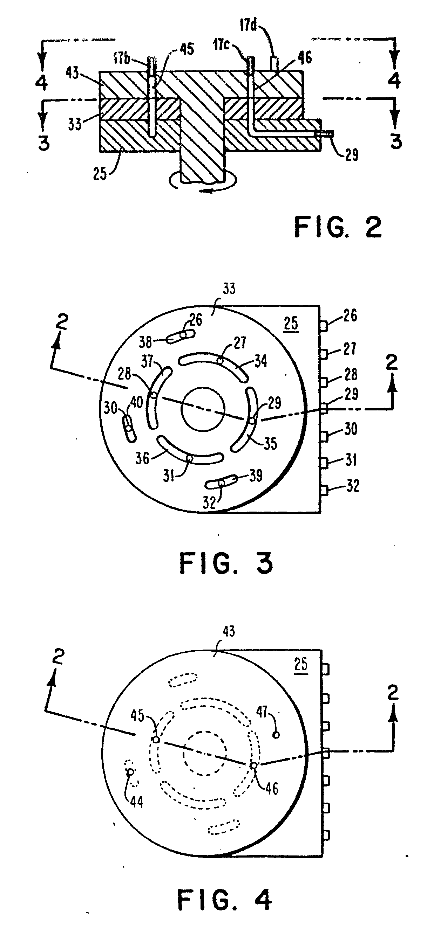

Das in Fig. 2 in einer Querschnittsdarstellung gezeigte Drehventil 16 besteht aus einem Verteilerkopf 25, einer festangeordneten Platte 33 und einer drehbar angeordneten Platte 43, die mit der Antriebswelle des Schrittmotors 24 verbunden ist. Der Verteilerkopf 25 enthält eine Anzahl von Verbindungskanälen 26, 27, 28, 29, 30, 31 und 32 (Fig. 3). Jeder dieser Kanäle ist durch eine Verbindungsleitung 19 mit dem Unterdruckerzeuger 20 bzw. dem Überdruckerzeuger 21 durch ein Ventil 22 bzw. 23 verbindbar, so dass zu vorgegebenen Zeitpunkten Unterdruck oder Überdruck zu den Verbindungskanälen 26 bis 32 übertragbar ist. Zur Vereinfachung der Darstellung ist die Anzahl der Verbindungsleitungen 19 und der diesen zugeordneten Ventile 22, 23 in Fig. 1 nur in Form einer einzigen Verbindungsleitung 19 mit den zugeordneten Ventilen 22 und 23 gezeigt.

Gemäss der Darstellung nach Fig. 3 münden die Enden der durch den Verteilerkopf 25 geführten Verbindungskanäle 27, 28, 29 und 31 in Durchgangsöffnungen 34, 35, 36, 37 der festangeordneten Platte 33, die auf einem inneren Kreis der festen Platte 33 angeordnet sind. Diese haben jeweils gleiche Bogenlängen und gleiche Winkelabstände. Die Enden der Verbindungskanäle 26, 30 und 32 münden in Durchgangsöffnungen 38, 39 und 40 der festen Platte 33, die auf einem äusseren Kreis der festangeordneten Platte vorgesehen sind. Diese haben gleiche Bogenlänge und verschiedene Winkelabstände. Die drehbar angeordnete Platte 43 enthält über dem inneren Kreis angeordnete, durch Verbindungsleitungen 17b und 17c mit den Düsen 62 der Tragkörper 12a und 13a verbundene durchgehende Bohrungen 45 und 46. In der drehbar angeordneten Platte 43 sind ferner über dem äusseren Kreis angeordnete durchgehende Bohrungen 44 und 47 vorgesehen, die durch Verbindungsleitungen 17a und 17d mit zylindrischen Kammern 61 der Tragköpfe 12a und 13a verbunden sind. Dadurch können von den Durchgangsöffnungen 34, 35, 36 und 37 der festangeordneten Platte 33, die über dem inneren Kreis angeordnet sind, Luftdruckänderungen zu den Verbindungsleitungen 17b und 17c übertragen werden, die mit den Düsen 62 der Tragköpfe 12a und 13a verbunden sind. Von den Durchgangsöffnungen 38, 39 und 40 der festangeordneten Platte 33 können durch die Verbindungsleitungen 17a und 17d Luftdruckänderungen zu den zylindrischen Kammern 61 der Tragköpfe 12a und 13a übertragen werden.

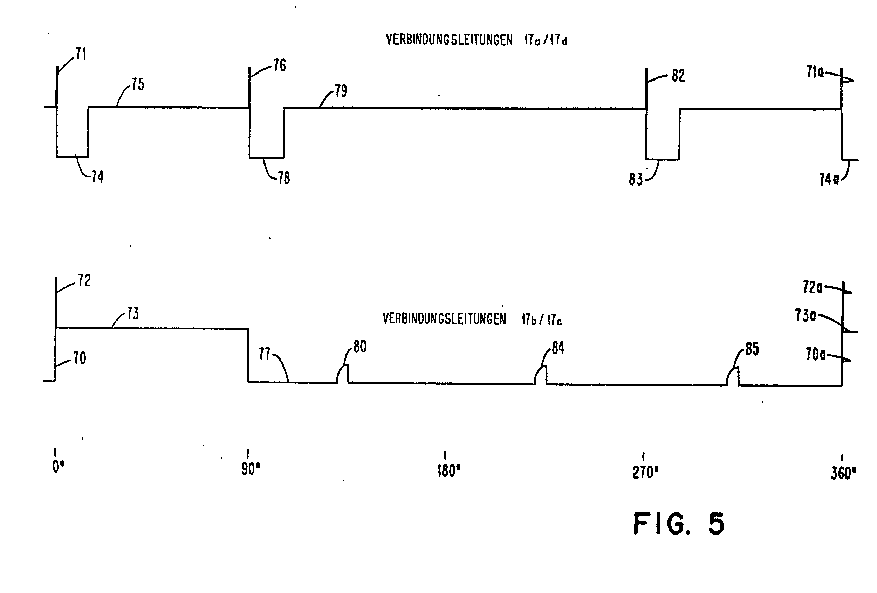

Die Fig. 5 zeigt das Diagramm von Luftdruckänderungen, die nach einem vorgegebenen Programm durch eine Verbindungsleitung 17a bzw. 17d zu der zylindrischen Kammer 64 des Tragkopfes 12a bzw. 13a übertragen werden, während dieser eine 360°-Umdrehung in Drehrichtung des Uhrzeigers ausführt. Während dieser Umdrehung werden ferner durch die Verbindungsleitung 17b bzw. 17c Luftdruckänderungen zu der Düse 62 des Tragkopfes 12a bzw. 13a übertragen, die ebenfalls durch ein Diagramm der Fig. 5 dargestellt sind. Die Diagramme der in den Verbindungsleitungen 17a und 17b auftretenden Luftdruckänderungen haben zu den Diagrammen der in den Verbindungsleitungen 17d und 17c auftretenden Luftdruckänderungen eine Phasenverschiebung von 180°.

Der in Fig. 1 gezeigte Tragkopf 12a besteht aus einem Gehäuse 60 mit einer zylindrischen Kammer 64, in welcher ein Kolben 61 mit einer an diesem befestigten Düse 62 in vertikaler Richtung durch einen in der zylindrischen Kammer wirkenden Überdruck gegen die Wirkung einer Feder 67 nach unten einstellbar ist. Gemäss der Darstellung nach Fig. 3 wird in der Anfangsstellung bei 0° des Drehventils 16 der Verbindungskanal 30 über die Durchgangsöffnung 40 der fest angeordneten Platte 33 und die durchgehende Bohrung 44 der drehbar angeordneten Platte 43 mit der Verbindungsleitung 17a verbunden. Entsprechend hierzu wird der Verbindungskanal 28 über die Durchgangsöffnung 37 der festangeordneten Platte 33 und die durchgehende Bohrung 45 der drehbar angeordneten Platte 43 mit der Verbindungsleitung 17b verbunden. Es sei angenommen, dass ein kleines Teil 68, z.B. ein Halbleiterchip durch die Wirkung von Unterdruck, welcher der Düse 62 zugeführt wird, an deren Mündung festgehalten wird. Dies ergibt sich gemäss der Darstellung nach Fig. 5 durch einen in der 0°-Stellung des Drehventils 16 durch die Verbindungsleitung 17b zu der Düse 62 übertragenen Impuls 70. Ein durch die Leitung 17a zu der zylindrischen Kammer 64 übertragener Überdruck-Impuls 71 drückt den Kolben 61 mit der Düse 62 nach unten, so dass das Halbleiterchip 68 an der Station 69 zur Bearbeitung aufgelegt wird. Wenn das Halbleiterchip 68 die Station 69 berührt, wird der Düse 62 durch die Leitung 17b anstelle des Unterdruckimpulses 70 ein Überdruckimpuls 72 zugeführt. Das Halbleiterchip 68 wird dadurch von der Mündung der Düse 62 abgestreift. Nach einer geeigneten Zeitdauer wird der in der Düse 62 bestehende Überdruck 72 auf atmosphärischen Druck geändert, wie dies durch die Linie 73 dargestellt ist. Nach Beseitigung des Überdrucks 72 in der Düse 62 wird der in der Kammer 64 bestehende Überdruck in Unterdruck geändert, wie dies durch den Impuls 74 dargestellt ist. Die mit dem Kolben 61 verbundene Düse 62 wird durch die Wirkung der Feder 67 und des Unterdruckimpulses 74 in die obere Ausgangslage zurückgestellt. Es erfolgt nun eine Synchronbetätigung der beiden Schrittmotoren 18 und 24, wodurch der Träger 11 und die drehbar angeordnete Platte 43 des Drehventils 16 im Uhrzeigersinn in Richtung des in Fig. 2 dargestellten Pfeiles um 90° gedreht werden. Wenn sich der Kolben 61 in seiner oberen Stellung befindet, wird er dort durch die Wirkung der Feder 67 festgehalten. Der Unterdruckimpuls 74 ist beendet, wenn die durchgehende Bohrung 44 der drehbar angeordneten Platte 43 die Durchgangsöffnung 40 der festangeordneten Platte 33 des Drehventils 16 überquert hat. Wenn sich die drehbar angeordnete Platte 43 des Drehventils 16 in die 90°-Stellung bewegt, wird durch die Verbindungsleitung 17a atmosphärischer Druck zu der zylindrischen Kammer 64 des Tragkopfes 12a übertragen, wie dies durch die Linie 75 dargestellt ist. Wenn der Tragarm 11 in der 90°-Stellung stillgesetzt wird, ist die durchgehende Bohrung 44 der drehbar angeordneten Platte 43 über der Durchgangsöffnung 38 der fest angeordneten Platte 33 des Drehventils eingestellt, wodurch die Verbindungsleitung 17a mit dem Verbindungskanal 26 verbunden ist. Gleichzeitig ist die durchgehende Bohrung 45 der drehbar angeordneten Platte 43 über der Durchgangsöffnung 34 der fest angeordneten Platte 33 angeordnet, wodurch die Verbindungsleitung 17b mit dem Verbindungskanal 27 verbunden ist.

In der 90°-Stellung wird vom Verbindungskanal 26 ein Überdruckimpuls 76 zu der Verbindungsleitung 17a übertragen, wodurch der Kolben 61 mit der Düse 62 abgesenkt wird. Gleichzeitig wird vom Verbindungskanal 27 durch die Verbindungsleitung 17b ein Unterdruckimpuls zu der Düse 62 übertragen, wie dies durch die Linie 77 dargestellt ist. Dieser Unterdruck in der Düse 62 hat zur Folge, dass ein nicht dargestelltes Halbleiterchip an die Mündung der Düse 62 angezogen wird. Durch einen nicht dargestellten Detektor wird festgestellt, ob ein Halbleiterchip durch die Düse 62 aufgenommen wurde. Wenn dies der Fall ist, wird durch die Verbindungsleitung 17a ein Unterdruckimpuls 78 zu der zylindrischen Kammer 64 übertragen, wodurch die Düse in ihre Ausgangslage zurückgeführt und in dieser durch die Feder 67 festgehalten wird.

Nach der Rückstellung des Kolbens 61 werden die Schrittmotoren 18 und 24 durch eine Synchronsteuerung gedreht, wodurch der Tragarm 11 und die drehbar angeordnete Platte 43 des Drehventils in die 180°-Stellung gelangen. Wenn die drehbar angeordnete Platte 43 gedreht wird, ergibt sich eine Unterbrechung des Unterdruckimpulses 78, so dass der zylindrischen Kammer 64 atmosphärischer Druck zugeführt wird, wie dies durch die Linie 79 dargestellt ist. Wenn die durchgehende Bohrung 45 der drehbar angeordneten Platte 43 das Ende der Durchgangsöffnung 34 der festangeordneten Platte 33 des Drehventils überschreitet, wird durch den Verbindungskanal 29 Unterdruck zu der Druchgangsöffnung 35 der festangeordneten Platte 33 des Drehventils übertragen. Obwohl beim Überschreiten des Abstandes zwischen den beiden Durchgangsöffnungen 34 und 35 durch die durchgehende Bohrung der drehbar angeordneten Platte 43 der Unterdruck in der Düse 62 kurzzeitig unterbrochen wird, ergibt sich nur eine kleine Druckerhöhung wie dies durch den in Fig. 5 gezeigten Impuls 80 dargestellt ist. Diese kleine Druckerhöhung hat nicht zur Folge, dass das Halbleiterchip von der Düse 62 abfällt.

Wenn der Tragkopf 12a die 180°-Stellung erreicht hat, werden die Schrittmotoren 18 und 24, welche den Träger 11 und die drehbar angeordnete Platte 43 des Drehventils antreiben, stillgesetzt. In dieser Stellung befindet sich die durchgehende Bohrung 45 des drehbar angeordneten Teils 43 des Drehventils 16 über der Durchgangsöffnung 35 des festangeordneten Teils 33, wodurch in der Düse 62 Unterdruck aufrechterhalten wird, so dass das Halbleiterchip an der Düse festgehalten bleibt. Da der Tragkopf 12a in dieser Stellung keine Betriebsfunktion auszuführen hat, wäre seine Stillsetzung in dieser Stellung nicht erforderlich. Da sich jedoch zu dieser Zeit der Tragkopf 13a in der 0°-Stellung befindet, in welcher dieser eine Betriebsfunktion auszuführen hat, ist es notwendig, den Tragkopf 12a in der 180°-Stellung an der gemeinsam befestigten Dreheinrichtung ebenfalls stillzusetzen.

Nach einer vorgegebenen Zeit bewirken die synchron angetriebenen Schrittmotoren 18 und 24 den Weitertransport des Tragkopfes 12a, wodurch die durchgehende Bohrung 45 der drehbar angeordneten Platte 43 des Drehventils von der Durchgangsöffnung 35 zu der Durchgangsöffnung 36 der fest angeordneten Platte 33 bewegt wird. Bei diesem Übergang ergibt sich in der Düse 62 kurzzeitig ein Druckanstieg, der durch den Impuls 84 in Fig. 5 dargestellt ist. Das Halbleiterchip 68 wird dadurch nicht von der Mündung der Düse 62 abgetrennt. Wenn der Tragkopf 12a die 270°-Stellung erreicht hat, befindet sich die durchgehende Bohrung 45 der drehbar angeordneten Platte 43 des Drehventils 16 über der Durchgangsöffnung 39 der festangeordneten Platte 33. In dieser Stellung werden die Schrittmotoren 18 und 24 stillgesetzt, so dass das am Ende der Düse 62 festgehaltene Halbleiterchip geprüft werden kann. Zu diesem Zweck wird von dem Verbindungskanal 32 über die Durchgangsöffnung 39 der fest angeordneten Platte 33 des Drehventils und die durchgehende Bohrung 44 der beweglich angeordneten Platte der in Fig. 5 dargestellte Überdruckimpuls 82 durch die Verbindungsleitung 17a zu der zylindrischen Kammer 64 des Tragkopfes 12a übertragen. Der Kolben 61 mit der Düse 62 wird dadurch niedergedrückt, wodurch das Halbleiterchip 68 mit der nicht dargestellten Prüfeinrichtung verbunden wird. Nach Beendigung des Prüfvorganges wird durch die Leitung 17a der Unterdruckimpuls 83 zu der zylindrischen Kammer 64 des Tragkopfes 12a übertragen, wodurch die Düse 62 in ihre Ausgangslage angehoben wird. Da es für den Prüfvorgang des Halbleiterchips 68 nicht erforderlich ist, dieses von der Düse 62 zu lösen, bleibt der Unterdruck während dieses Vorganges in der Düse aufrechterhalten, wie dies durch die Linie 77 der Fig. 5 dargestellt ist. Nach Beendigung des Prüfvorganges bewirken die synchron angetriebenen Schrittmotoren 18 und 24 den Weitertransport des Tragkopfes 12a und der drehbar angeordneten Platte 43 des Drehventils 16, wodurch der Tragkpof 12a in die 360°-Stellung gelangt. Wenn der Tragkopf 12a die 360°-Stellung erreicht, befinden sich die durchgehenden Bohrungen 44 bzw. 45 der drehbar angeordneten Platte 43 des Drehventils 16 über den Durchgangsöffnungen 40 bzw. 37 der fest angeordneten Platte 33, wodurch der Tragkopf 12a seine Ausgangsstellung wieder erreicht hat. Ein neuer Umlauf des Tragkopfes 12a beginnt mit Druckänderungen in den Verbindungsleitungen 17a und 17b bzw. 17c und 17d, wie dies in Fig. 5 durch die Impulse 70a, 71a, 72a, 73a und 74a dargestellt ist.

Aus der Darstellung der Fig. 1 geht hervor, dass der Träger 11 mit den Tragarmen 12 und 13 durch den Schrittmotor 18 und das Drehventil 16 durch den Schrittmotor 24 angetrieben werden. Die Drehlager des Trägers 11 und des Drehventils 16 sind voneinander getrennt. Am Drehventil 16 ergeben sich Reibkräfte, deren Beträge durch die Druckänderungen in den Durchgangsöffnungen der festangeordneten Platte 33 des Drehventils erheblich beeinflusst werden. Ein gemeinsames Drehlager für den Träger 11 und das Drehventil 16 hätte zur Folge, dass für die Dreheinstellungen des Trägers 11 verschiedene Antriebskräfte aufgebracht werden müssten, um gleichbleibende Dreheinstellungen zu erzielen. Da dem Träger 11 und dem Drehventil 16 jeweils ein eigenes Drehlager zugeordnet ist, bleibt der Reibungswiderstand am Drehlager des Trägers 11 konstant. Die Genauigkeit der Dreheinstellungen der Tragköpfe 12a und 13a wird dadurch gewährleistet.

**Patentansprüche**

1. Einrichtung für das Aufnehmen/Ablegen und Transportieren von kleinen Werkstücken, z.B. von Halbleiterchips, an Bearbeitungsstationen, die entlang einer Kreisbahn angeordnet sind, mit einer Anzahl von über der Kreisbahn bewegbaren Düsen, die an einer Hub- und Dreheinrichtung schrittweise in vorgegebenen Winkelstellungen der Dreheinrichtung in eine Bearbeitungsebene abgesetzt und aus dieser angehoben werden und mit einem Drehventil, durch das in den Winkelstellungen der Dreheinrichtung nach einem vorgegebenen Programm zu den Düsen Unterdruck/Überdruck für das Aufnehmen/Ablegen von Werkstücken übertragbar ist, dadurch gekennzeichnet, dass jede Düse (62) mit einer pneumatisch betätigbaren Hub- und Senkeinrichtung ausgestattet ist, die über eine Verbindungsleitung (17a, 17d) durch das Drehventil (16) steuerbar ist und aus einer luftdicht verschlossenen, zylindrischen Kammer (64) besteht, in welcher ein mit der Düse (62) verbundener Kolben (61) gegen den Druck einer Feder (67) durch Überdruck in die Senkposition einstellbar und durch die Summe von Federdruck und einstellbarem Unterdruck in die Hubposition rückstellbar ist.

2. Einrichtung nach Anspruch 1, dadurch gekennzeichnet, dass das Drehventil (16) eine fest angeordnete Platte (33) enthält, die auf einem inneren Kreis angeordnete, gleiche Bogenlängen und Winkelabstände aufweisende Durchgangsöffnungen (36, 35, 34, 37) und auf einem äusseren Kreis angeordnete, gleiche Bogenlänge und verschiedene Winkelabstände aufweisende Durchgangsöffnungen (38, 39, 40) enthält, von denen jede über einen Verbindungskanal (26 - 32), eine Verbindungsleitung (19) und Ventile (22, 23) wahlweise mit einem Überdruck- oder einem Unterdruckerzeuger (20, 21) verbindbar ist.

3. Einrichtung nach Anspruch 2, dadurch gekennzeichnet, dass das Drehventil (16) über der fest angeordneten Platte (33) eine drehbar angeordnete Platte (43) enthält, die über dem inneren Kreis angeordnete, durch Verbindungsleitungen (17b, 17c) mit Düsen (62) verbundene Bohrungen (45, 46) und über dem äusseren Kreis angeordnete, durch Verbindungsleitungen (17a, 17d) mit einer zylindrischen Kammer (64) der Hub- und Senkeinrichtung verbundene Bohrungen (44, 47) aufweist.

4. Einrichtung nach Anspruch 3, dadurch gekennzeichnet, dass die an einem drehbaren Träger (11) angeordneten Düsen (62) durch einen Schrittmotor (18) in aufeinanderfolgende Winkelpositionen einstellbar sind, dessen Schrittbewegungen mit den Dreheinstellungen eines Schrittmotors (24) synchronisiert sind, der die drehbar angeordnete Platte (43) des Drehventils (16) antreibt.

**Claims**

1. An apparatus for picking up/depositing and transferring small workpieces, e.g., semiconductor chips, to processing stations positioned along an arcuate path, with a plurality of needles movable above the arcuate path, which at lifting and rotary means are lowered in steps at given angular positions of the rotary means onto a processing plane and are lifted therefrom, and with a rotary valve by means of which at the angular positions of the rotary means vacuum/pressure for picking up/depositing workpieces can be applied to the needles according to a given programme, characterized in that each needle (62) is provided with pneumatically actuatable lifting and lowering means controlled through flexible tubings (17a, 17d) by the rotary valve (16) and consisting of an airtight, cylindrical chamber (64) in which a piston (61) connected to the needle (62) can be forced by pressure to the down position against the tension of a spring (67) and the returned to the up position by the sum of spring tension and adjustable vacuum.

2. The apparatus according to claim 1, characterized in that the rotary valve (16) comprises a fixed plate (33) with arcuate channels (36, 35, 34, 37), positioned along an inner arc and having the same arc lengths and angular spacings, and arcuate channels (38, 39, 40), positioned along on an outer arc and having the same arc lengths but different angular spacings, each of said channels being selectively connectable to a pressure or vacuum generator (20, 21) through conduits (26 - 32), piping (19) and valves (22, 23).

3. The apparatus according to claim 2, characterized in that the rotary valve (16) is provided with a rotary plate (43) above the fixed plate (33), plate (43) having through holes (45, 46), positioned above the inner arc and connected by tubings (17b, 17c) to the needles (62), and through holes (44, 47) positioned above the outer arc and connected by tubings (17a, 17d) to a cylindrical chamber (64) of the lifting and lowering means.

4. The apparatus according to claim 3, char-

acterized in that the needles (62) carried by a turret (11) can be adjusted by a stepping motor (18) to successive angular positions, the stepping motions of said stepping motor (18) being synchronized with the stepping motions of a second stepping motor (24) which drives the rotatably mounted plate (43) of the rotary valve (16).

## Revendications

1. Dispositif pour saisir, déposer et transporter de petites pièces à travailler, par exemple des microplaquettes semi-conductrices, à des stations de traitement disposées le long d'un chemin incurvé, munis de plusieurs buses, mobiles au-dessus du chemin incurvé, qui sont, à l'aide d'un moyen de soulèvement et de rotation, déposées par pas à des positions angulaires données du moyen de rotation, dans un plan de traitement et soulevées hors de celui-ci, et d'une soupage rotative, par laquelle, aux positions angulaires du moyen rotatif, une dépression ou une pression est transféré aux buses pour la saisie ou le dépôt des pièces de travail selon un programme prévu, caractérisé en ce que chaque aiguille (62) comporte des moyens de soulèvement et d'abaissement à actionnement pneumatique commandés au travers de canalisations de liaison (17a, 17d) par la soupape rotative (16) et formés d'une chambre cylindrique fermée étanche à l'air (64) dans laquelle un piston (61) lié à la buse (62) peut être amené par la pression en position basse à l'encontre de la pression exercée par un ressort (67) et ramené en position haute par la somme de la pression du ressort et de la dépression réglable.

2. Dispositif selon la revendication 1, caractérisé en ce que la soupape rotative (16) comprend une plaque fixe (33) munie d'ouvertures de passage (36, 35, 34, 37) disposées le long d'un arc intérieur et présentant des mêmes longueurs d'arc et des mêmes distances angulaires, et d'ouvertures de passage (38, 39, 40) disposées le long d'un arc extérieur et présentant des mêmes longueurs d'arc et des distances angulaires différentes, chacune de ces ouvertures pouvant être sélectivement raccordée à un générateur de pression ou de dépression (20, 21) au travers des canaux de liaison (26 à 32), d'une canalisation de liaison (19) et des soupages (22, 23).

3. Dispositif selon la revendication 2, caractérisé en ce que la soupape rotative (16) comprend, au-dessus de la plaque fixe (33), une plaque rotative (43) présentant des alésages (45, 46) disposés au-dessus de l'arc intérieur et reliés par des canalisations de liaison (17b, 17c) aux buses (62), et des alésages (44, 47) disposés au-dessus de l'arc extérieur et reliés par des canalisations de liaison (17a, 17d) à une chambre cylindrique (64) du moyen de soulèvement et d'abaissement.

4. Dispositif selon la revendication 3, caractérisé en ce que les buses (62) disposées sur un support rotatif (11) peuvent être placées dans des positions angulaires successives par un moteur pas-à-pas (18), dant les mouvements de pas sont synchronisés avec les positions de rotation d'un moteur pas-à-pas (24) actionnant la plaque montée à rotation (43) de la soupage rotative (16).

FIG. 1

FIG. 2

FIG. 3

FIG. 4

VERBINDUNGSLEITUNGEN 17a/17d

71 75 76 79 82 71a
74 78 83 74a

VERBINDUNGSLEITUNGEN 17b/17c

72 73 72a
70 77 80 84 85 73a
70a

0° 90° 180° 270° 360°

## FIG. 5